# EUROPEAN PATENT APPLICATION

(11) **EP 4 765 321 A1**
(43) Date of publication of application: **24.06.2026**
(21) Application number: 24894478.7
(22) Date of filing: 08.11.2024
(51) Int. Cl.: H01M 10/48, H01M 10/42, H01M 50/178, G01R 31/382, G01K 7/02

(54) **BATTERY MODULE AND BATTERY PACK COMPRISING SAME**

(30) Priority: 22.11.2023 KR 20230163575
(71) Applicant: LG Energy Solution, Ltd., Seoul 07335 (KR)
(72) Inventor: KIM, Jin Hyung, Daejeon 34122 (KR); KIM, Mi Na, Daejeon 34122 (KR); YOON, Hye Jung, Daejeon 34122 (KR)
(74) Representative: Goddar, Heinz J.
(86) International application number: PCT/KR2024/017600
(87) International publication number: WO 2025/110585

(57) **Abstract**

The present disclosure relates to a battery module and a battery pack including the same, and a battery module according to one aspect of the present disclosure may include a battery cell including a cell body and a first electrode lead and a second electrode lead provided on one side and the other side of the cell body, respectively; a first voltage measuring member and a second voltage measuring member electrically connected to the first electrode lead and the second electrode lead, respectively; and a temperature measuring member coupled to the first electrode lead to form a thermocouple with the first voltage measuring member.

## Description

### TECHNICAL FIELD

### CROSS-REFERENCE TO RELATED APPLICATIONS

The present application claims priority to Korean Patent Application No. 10-2023-0163575 filed on November 22, 2023 in the Republic of Korea, the disclosures of which are incorporated herein by reference.

### TECHNICAL FIELD

The present disclosure relates to a battery module and a battery pack including the same, and more specifically, to a battery module provided with a battery cell composed of a secondary battery and a battery pack including the same.

### BACKGROUND ART

Secondary batteries have been applied to small-sized applications such as mobile devices or laptop computers, but recently, the research direction has been expanded to medium and large-sized applications, and they are widely used in applications requiring high voltage and large capacity in relation to energy storage systems (ESSs) or electric vehicles (EVs).

When multiple battery cells composed of such secondary batteries are integrated and packaged, a battery module may be formed, and when multiple battery modules are integrated and packaged, a battery pack may be formed. Such battery modules and battery packs may perform a function of charging and discharging electric energy.

The battery cells constituting the battery module or battery pack may be controlled by a battery management system (BMS). The battery management system may obtain information about the state of the battery cells and control the battery cells individually based on this information. Through this, the battery management system may manage multiple battery cells in an integrated manner.

This battery management system may obtain information about the capacity of the battery cell, the voltage or current applied to the battery cell, the temperature of the battery cell, and the like as information about the state of the battery cell. At this time, various methods such as installing a separate temperature sensor in the battery cell have been proposed to obtain information about the temperature of the battery cell.

To measure the temperature of the battery cell, a method of using a thermocouple may be considered. The thermocouple is a device that connects different metal wires to measure temperature using the thermoelectric effect.

However, to measure the temperature of the battery cell using such a thermocouple, a separate electric circuit for configuring the thermocouple should be prepared on the side of the battery cell, which has the problem of reducing the space utilization and the degree of design freedom inside the battery module.

Accordingly, there has been an urgent need for the development of a battery module capable of measuring the temperature of the battery cell using a thermocouple with a simple and compact structure, and a battery pack including the same.

### SUMMARY

### TECHNICAL PROBLEM

The present disclosure is designed to solve the problems of the related art, and therefore the present disclosure is directed to providing a battery module capable of measuring the temperature of battery cells using a thermocouple with a simple and compact structure and a battery pack including the same.

Technical problems of the present disclosure are not limited to the above-described problems, and other problems not mentioned herein may be clearly understood by those having ordinary skill in the art from the following description of the present disclosure.

### TECHNICAL SOLUTION

According to one aspect of the present disclosure, there is provided a battery module including a battery cell including a cell body and a first electrode lead and a second electrode lead provided on one side and the other side of the cell body, respectively; a first voltage measuring member and a second voltage measuring member electrically connected to the first electrode lead and the second electrode lead, respectively; and a temperature measuring member coupled to the first electrode lead to form a thermocouple with the first voltage measuring member.

At this time, the battery module may further include a battery management system for controlling an operation of the battery cell, wherein the battery management system may include a voltage measuring unit that measures a voltage between the first voltage measuring member and the temperature measuring member or a voltage between the first voltage measuring member and the second voltage measuring member.

At this time, the battery management system may further include a processor unit that calculates a temperature of the battery cell based on a voltage difference between the first voltage measuring member and the temperature measuring member.

At this time, the battery module may further include a reference temperature member that exchanges heat with a portion of the first voltage measuring member and a portion of the temperature measuring member.

At this time, the reference temperature member may exchange heat so that a portion of the first voltage measuring member and a portion of the temperature measuring member have the same temperature.

At this time, the battery module may further include a temperature sensor for measuring a temperature of the reference temperature member.

At this time, the battery management system may further include a processor unit that calculates a temperature of the battery cell based on a voltage between the first voltage measuring member and the temperature measuring member and a temperature of the reference temperature member.

At this time, the battery management system may further include a circuit switching unit capable of controlling electrical connections between the first voltage measuring member, the second voltage measuring member and the temperature measuring member, and the voltage measuring unit.

At this time, the first electrode lead may include a metal layer and a coating layer covering an outer surface of the metal layer, and a groove or hole where the metal layer is exposed to the outside may be formed, wherein one side of the temperature measuring member may be in contact with an inner wall of the groove or hole of the first electrode lead.

At this time, the one side of the temperature measuring member may have a ring shape capable of being caught in the groove or hole.

At this time, the one side of the temperature measuring member may be coupled to an inner wall of the groove or hole.

At this time, the one side of the temperature measuring member may be welded to a bottom surface of the groove.

At this time, the first voltage measuring member may be made of copper having a purity of 99.5% or more, and the temperature measuring member may be made of constantan.

At this time, the battery cell may be provided in plurality, and the first voltage measuring member, the second voltage measuring member, and the temperature measuring member may be provided in plurality corresponding to the number of battery cells.

According to another aspect of the present disclosure, there is provided a battery pack including a battery module described above.

### ADVANTAGEOUS EFFECTS

In a battery module according to one aspect of the present disclosure and a battery pack including the same, a portion of a thermocouple for measuring the temperature of a battery cell is configured as a voltage measuring member for measuring the voltage of the battery cell, so that the temperature of the battery cell may be measured through a simple and compact circuit structure.

In a battery module according to one aspect of the present disclosure and a battery pack including the same, the temperature of the battery cell itself is directly calculated by using the potential difference of a thermocouple directly connected or coupled to the electrode lead of the battery cell, so that the temperature of the battery cell may be measured more accurately compared to a method of indirectly measuring the temperature of the battery cell through thermal conduction.

Effects to be obtained by the present disclosure are not limited to the above-described effects, and other effects not mentioned herein may be clearly understood by those having ordinary skill in the art from this specification and the accompanying drawings.

### BRIEF DESCRIPTION OF THE DRAWINGS

FIG. 1 is a view schematically showing a battery module according to the first embodiment of the present disclosure.
FIG. 2 is an enlarged view of a portion of FIG. 1.
FIG. 3 is a cross-sectional view showing a state in which a temperature measuring member is coupled to a first electrode lead of a battery module according to the first embodiment of the present disclosure.
FIG. 4 is a cross-sectional view showing a state in which a temperature measuring member is coupled to a first electrode lead of a battery module according to the second embodiment of the present disclosure.

### DETAILED DESCRIPTION

Preferred embodiments of the present disclosure will be described in detail to enable those skilled in the art to easily carry out the present disclosure. However, the present disclosure may be embodied in many different forms and is not limited or restricted by the following embodiments.

To clearly describe the present disclosure, an irrelevant description or a detailed description of related known technology that may unnecessarily obscure the gist of the present disclosure is omitted, and in affixing the reference numerals to the elements in each drawing, the identical or similar reference numerals are affixed to the identical or similar elements throughout the present disclosure.

Additionally, it should be understood that the terms or words used in the present disclosure and the appended claims should not be construed as limited to general and dictionary meanings, but rather interpreted based on the meanings and concepts corresponding to the technical aspect of the present disclosure on the basis of the principle that the inventor is allowed to define terms appropriately for the best explanation.

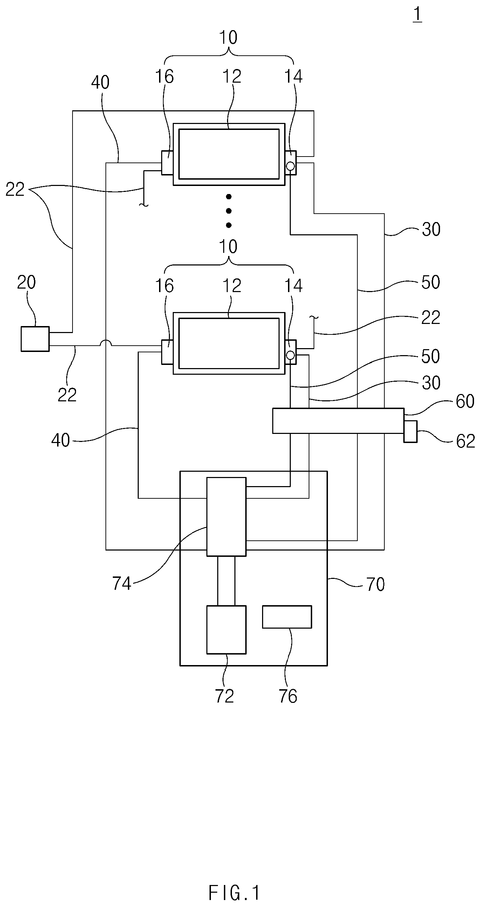

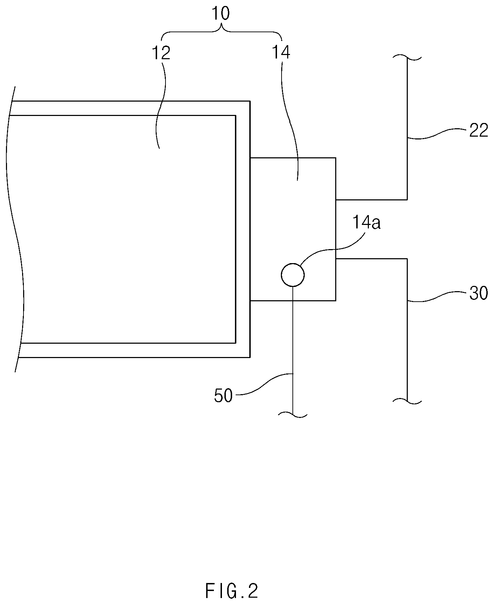

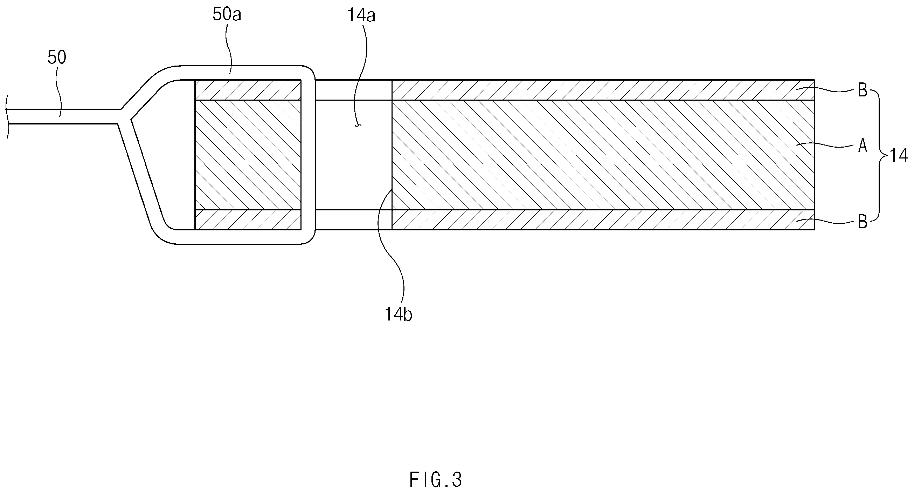

FIG. 1 is a view schematically showing a battery module according to the first embodiment of the present disclosure. FIG. 2 is an enlarged view of a portion of FIG. 1. FIG. 3 is a cross-sectional view showing a state in which a temperature measuring member is coupled to a first electrode lead of a battery module according to the first embodiment of the present disclosure.

At this time, each component of the battery module according to the first embodiment of the present disclosure is schematically shown in FIGS. 1 to 3, and the size of the component, the thickness of the line, and the like may be somewhat exaggerated for convenience of understanding.

In FIGS. 1 to 3, a battery module 1 according to the first embodiment of the present disclosure is disclosed. The battery module 1 according to the first embodiment of the present disclosure is a device for storing electric energy or releasing electric energy to the outside. In other words, the battery module 1 may charge and discharge electric energy.

To this end, the battery module 1 according to the first embodiment of the present disclosure may include a battery cell 10. In this embodiment, the battery cell 10 may be responsible for the charging and discharging function of the battery module 1.

The battery cell 10 according to this embodiment may include a cell body 12. An electrode assembly may be provided in the cell body 12. The shape or structure of the cell body 12 may be appropriately formed depending on the type or form of the electrode assembly.

As an example, the cell body 12 may be provided in a pouch form, as shown. A stacked electrode assembly, a folding electrode assembly, or the like may be accommodated in such a pouch-type cell body 12, but is not limited thereto. As another example, the cell body 12 may be provided in a cylindrical shape corresponding to the structure of a wound electrode assembly.

In this embodiment, the electrode assembly provided in the cell body 12 of the battery cell 10 may be electrically connected to an external load or power source. To this end, the battery cell 10 may include a first electrode lead 14 and a second electrode lead 16. The first electrode lead 14 and the second electrode lead 16 may be leads for electrically connecting the electrode assembly provided in the cell body 12 to the outside.

At this time, one of the first electrode lead 14 and the second electrode lead 16 may be an electrode lead connected to the positive electrode of the electrode assembly, and the other may be an electrode lead connected to the negative electrode of the electrode assembly. In other words, the first electrode lead 14 and the second electrode lead 16 may have different electrical properties.

As an example, the first and second electrode leads 14, 16 may have a film or sheet shape extending outward from the cell body 12. As another example, the first and second electrode leads 14, 16 may be composed of a metal piece (or pieces of metal) provided on the outside of the cell body 12. Hereinafter, the first and second electrode leads 14, 16 according to this embodiment will be described on the premise that they have a film or sheet shape.

Meanwhile, referring to FIGS. 2 and 3, the first electrode lead 14 may include a conductive metal body A in this embodiment. The metal body A may be a structure that is electrically connected to the electrode assembly of the cell body 12 and has a potential accordingly. As an example, the metal body A may be a thin plate made of copper Cu having a purity of 99.5% or more, but the shape or type of material of the metal body A is not limited thereto.

In this embodiment, the first electrode lead 14 may include a coating layer B. The coating layer B may be provided on the outer surface of the metal body A to cover it. As an example, the coating layer B may be a protective layer for protecting the metal body A.

In this embodiment, the coating layer B may be made of nickel Ni or an alloy containing nickel. And, the coating layer B may be formed on the outer surface of the metal body A through a plating process. However, the type of metal constituting the coating layer B or the method of forming it is not limited to those described above.

Meanwhile, the coating layer B may be provided on only one surface of the metal body A. Alternatively, the coating layer B may be configured to cover only a partial area of one surface of the metal body A.

Referring to FIGS. 2 and 13, the first electrode lead 14 may be configured such that at least a portion of the metal body A is exposed to the outside. To this end, a hole 14a may be formed in the first electrode lead 14 in this embodiment.

In this embodiment, the hole 14a may be formed through the first electrode lead 14 in a thickness direction thereof. Accordingly, the metal body A may be exposed through an inner wall of the hole 14a. A tab processing process may be performed to form such a hole 14a, but the process for forming the hole 14a is not limited to those described above.

Meanwhile, in this embodiment, the battery cell 10 may be configured in plurality. And, the plurality of battery cells 10 may be arranged and electrically connected in a predetermined manner. Through this, the electric capacity of the battery module 1 may be increased.

For example, as shown, the plurality of battery cells 10 may be arranged in a row. And, the plurality of battery cells 10 may be connected in series. Of course, the plurality of battery cells 10 may be arranged in a grid form, and some of the plurality of battery cells 10 may be connected in parallel while the rest may be connected in series. The arrangement method or connection method of the battery cells 10 may be appropriately changed as necessary.

Referring to FIG. 1, the battery module 1 according to the first embodiment of the present disclosure may include a connector 20. The connector 20 may be configured to electrically connect the above-described battery cells 10 to an external power source or load. The connector 20 may be configured as a terminal or the like, but is not limited thereto.

Meanwhile, in this embodiment, a connecting member 22 may be provided to electrically connect the plurality of battery cells 10 to each other or to electrically connect the battery cells 10 and the connector 20.

In this embodiment, the connecting member 22 may be composed of a wire, a circuit formed on a flexible circuit board (FCB) or a flat flexible cable (FFC), a busbar, or the like. However, the structure or type of the connecting member 22 is not particularly limited as long as it may connect the battery cells 10 to each other or connect the battery cells 10 and the connector 20.

Meanwhile, the battery module 1 according to the first embodiment of the present disclosure may include a first voltage measuring member 30 and a second voltage measuring member 40. The first voltage measuring member 30 and the second voltage measuring member 40 may be members for measuring a voltage of the battery cell 10.

To this end, the first voltage measuring member 30 and the second voltage measuring member 40 may be electrically connected (or coupled) to the first electrode lead 14 and the second electrode lead 16, respectively. More specifically, the first voltage measuring member 30 may be coupled to the metal body A (shown in FIG. 3) of the first electrode lead 14.

The first voltage measuring member 30 and the second voltage measuring member 40 may be composed of a wire, a circuit formed on a flexible circuit board or a flat flexible cable, a busbar, or the like. However, the type or structure of the first voltage measuring member 30 and the second voltage measuring member 40 is not particularly limited as long as they may be subjected to the same potential as the first electrode lead 14 and the second electrode lead 16 described above, respectively.

Accordingly, in the battery module 1 according to this embodiment, a voltage of the battery cell 10 may be calculated by measuring a potential difference between the first voltage measuring member 30 and the second voltage measuring member 40.

At this time, the measurement of the potential difference between the first voltage measuring member 30 and the second voltage measuring member 40 may be performed by a voltage measuring unit 72 of a battery management system 70 (BMS) to be described later. This will be described later together with the battery management system 70.

Meanwhile, to allow the voltages of the plurality of battery cells 10 to be individually measured, the first voltage measuring member 30 and the second voltage measuring member 40 may be configured in plurality corresponding to the number of the plurality of battery cells 10. In other words, a pair of conductive members (hereinafter referred to as voltage measuring member pairs 30, 40) composed of the first voltage measuring member 30 and the second voltage measuring member 40 may be connected to each battery cell 10.

Meanwhile, referring to FIGS. 1 to 3, the battery module 1 according to the first embodiment of the present disclosure may include a temperature measuring member 50. In this embodiment, the temperature measuring member 50 may be a member for measuring the temperature of the battery cell 10 using the seebeck effect.

To this end, the temperature measuring member 50 may have one side 50a coupled to the first electrode lead 14. And, the temperature measuring member 50 may form a thermocouple together with the first voltage measuring member 30 connected to the first electrode lead 14.

In this embodiment, the temperature of the battery cell 10 may be measured by using the characteristics of the thermocouple. More specifically, the temperature of the battery cell 10 may be measured by measuring the potential difference between the first voltage measuring member 30 and the temperature measuring member 50.

At this time, the potential difference between the first voltage measuring member 30 and the temperature measuring member 50 may be performed by the voltage measuring unit 72 of the battery management system 70 to be described later. This will be described later together with the battery management system 70.

The temperature measuring member 50 may be composed of a wire, a circuit formed on a flexible circuit board or a flat flexible cable, a busbar, or the like. However, the temperature measuring member 50 may be transformed into various types of members capable of forming a thermocouple with the first voltage measuring member 30.

As a more specific example, the temperature measuring member 50 may be provided in the form of a circuit on a substrate or cable. At this time, the temperature measuring member 50 and the first voltage measuring member 30 may be formed together on the same substrate or cable, or they may be formed respectively on different substrates or cables.

Meanwhile, materials of the temperature measuring member 50 and the first voltage measuring member 30 may be appropriately selected to form a thermocouple. As an example, the temperature measuring member 50 may be made of constantan, and the first voltage measuring member 30 may be made of copper having a purity of 99.5% or more.

As such, according to the first embodiment of the present disclosure, a thermocouple having a simpler and more compact structure may be configured by utilizing the first voltage measuring member 30 for measuring the voltage of the battery cell 10. This allows the temperature of the battery cell 10 to be measured simply and accurately.

Meanwhile, referring to FIG. 3, one side 50a of the temperature measuring member 50 may be coupled to be in contact with the metal body A of the first electrode lead 14 in this embodiment. To this end, one side 50a may be coupled to the hole 14a of the first electrode lead 14 described above. At this time, one side 50a may have a ring shape capable of being caught in the hole 14a.

Accordingly, the temperature measuring member 50 may be electrically connected to the metal body A of the first electrode lead 14. On the other hand, to stably maintain the contact between one side 50a of the temperature measuring member 50 and the metal body A of the first electrode lead 14, a portion of one side 50a may be welded to the inner wall of the hole 14a.

Meanwhile, to allow the temperature of the plurality of battery cells 10 to be individually measured, the temperature measuring member 50 may be configured in plurality corresponding to the number of the plurality of battery cells 10. In other words, a pair of conductive members (hereinafter referred to as temperature measuring member pairs 30, 50) composed of the first voltage measuring member 30 and the temperature measuring member 50 may be connected to each battery cell 10.

Referring to FIG. 1 again, the battery module 1 according to the first embodiment of the present disclosure may include a reference temperature member 60. The reference temperature member 60 may be configured to exchange heat with a portion of the first voltage measuring member 30 and a portion of the temperature measuring member 50.

Through this, a portion of the first voltage measuring member 30 and a portion of the temperature measuring member 50 may be constantly maintained at the same temperature (hereinafter, referred to as the reference temperature). At this time, it should be understood that the temperature of the two configurations being the same includes that even if there is a slight difference in the temperature of the two configurations, it is within an allowable range of error in the process of calculating the temperature using the thermocouple.

In this embodiment, the reference temperature member 60 may be provided as a block-shaped member which a portion of the first voltage measuring member 30 and a portion of the temperature measuring member 50 pass through or are in contact with. However, the structure or shape of the reference temperature member 60 is not particularly limited as long as it may exchange heat with the first voltage measuring member 30 and the temperature measuring member 50.

In this embodiment, the reference temperature member 60 may be maintained at a constant reference temperature. Therefore, a portion of the first voltage measuring member 30 and a portion of the temperature measuring member 50 may be maintained at a constant temperature. To this end, the reference temperature member 60 may be made of a material having a large heat capacity. Alternatively, the reference temperature member 60 may be provided with a separate temperature control device such as a heat exchanger.

Meanwhile, the battery module 1 according to the first embodiment of the present disclosure may include a temperature sensor 62 for measuring the reference temperature of the reference temperature member 60. The temperature sensor 62 may be composed of various types of sensors capable of measuring the temperature of the reference temperature member 60.

In this embodiment, the reference temperature measured by the temperature sensor 62 may be used for a processor 76 of the battery management system 70 to be described later to calculate the temperature of the battery cell 10. This will be described later together with the battery management system 70.

Meanwhile, the temperature sensor 62 described above may not be provided separately. For example, if the reference temperature member 60 is configured to be constantly maintained at a specific temperature, the temperature sensor 62 may not be provided separately.

Referring to FIG. 1, the battery module 1 according to the first embodiment of the present disclosure may include a battery management system 70. The battery management system 70 may be a controller for controlling the operation of the battery cell 10.

At this time, the battery management system 70 may obtain information about the state of the battery cell 10 and manage the battery cell 10 individually based on this information. Through this, integrated management and control of the battery cell 10 may be achieved. The state of the battery cell 10 may include a voltage, a temperature, and the like of the battery cell 10.

In this embodiment, the battery management system 70 may include a voltage measuring unit 72 and a processor 76. The voltage measuring unit 72 may be configured to measure a potential difference between the first voltage measuring member 30 and the second voltage measuring member 40 or a potential difference between the first voltage measuring member 30 and the temperature measuring member 50.

As an example, the voltage measuring unit 72 may be composed of a voltmeter. The type or structure of this voltage measuring unit 72 may be changed to various types of circuits or devices capable of measuring the potential difference between the two members as necessary.

In this embodiment, the processor 76 may be configured to calculate information about the state of the battery cell 10 based on the potential difference measured by the voltage measuring unit 72. For example, the processor 76 may be configured to calculate a voltage or temperature of the battery cell 10.

To this end, the processor 76 may include an electric circuity, a processor, a central processing unit (CPU), a controller, an arithmetic logic unit, an operational logic circuit, a digital signal processing device, a microcomputer, an FPGA, a system on a chip (SoC), a programmable logic unit, a microprocessor, or any device capable of performing the functions described below.

In this embodiment, the processor 76 may calculate the voltage of the battery cell 10 using the potential difference measured by the voltage measuring unit 72. For example, the processor 76 may calculate the potential difference between the first voltage measuring member 30 and the second voltage measuring member 40 as the voltage of the battery cell 10 connected thereto.

In this embodiment, the processor 76 may calculate the temperature of the battery cell 10 using the potential difference measured by the voltage measuring unit 72. For example, the processor 76 may calculate the temperature of the battery cell 10 connected to the first voltage measuring member 30 and the temperature measuring member 50 based on the potential difference therebetween.

As a specific example, the processor 76 may calculate the temperature of the battery cell 10 using a pre-obtained data set. The data set may be stored in the processor 76 in advance, or may be transmitted from the outside through a predetermined communication unit. At this time, the data set may be a set of data composed of a potential difference and a temperature of the battery cell 10 corresponding thereto.

At this time, in this embodiment, the processor 76 may calculate the temperature of the battery cell 10 using the reference temperature of the reference temperature member 50 together. At this time, the reference temperature may be a temperature measured by the temperature sensor 62.

As a specific example, the processor 76 may calculate the temperature of the battery cell 10 using a pre-obtained data set. The data set may be stored in the processor 76, or may be transmitted from the outside through a predetermined communication unit. At this time, the data set may be a set of data composed of a potential difference, a reference temperature, and a temperature of the battery cell 10 corresponding thereto.

Meanwhile, the above-described method is only an example of the method in which the processor 76 calculates the temperature of the battery cell 10 by using the potential difference between the first voltage measuring member 30 and the temperature measuring member 50, and the method in which the processor 76 calculates the temperature of the battery cell 10 by using the potential difference between the first voltage measuring member 30 and the temperature measuring member 50 may be appropriately modified as necessary.

Referring to FIG. 1 again, the battery management system 70 may include a circuit switching unit 74 in this embodiment. The circuit switching unit 74 is configured to electrically connect the voltage measuring unit 72 to at least one of the first voltage measuring member 30, the second voltage measuring member 40, and the temperature measuring member 50.

To this end, the circuit switching unit 74 may be configured as an electrical element, an electrical circuit, or a pattern that may selectively connect a particular circuit among multiple circuits.

In this embodiment, the circuit switching unit 74 may selectively connect the voltage measuring unit 72 to the first voltage measuring member 30 and the second voltage measuring member 40 connected to a particular battery cell 10. Through this, the processor 76 may calculate the voltage of the particular battery cell 10.

In this embodiment, the circuit switching unit 74 may selectively connect the voltage measuring unit 72 to the first voltage measuring member 30 and the temperature measuring member 50 connected to a particular battery cell 10. Through this, the processor 76 may calculate the temperature of the particular battery cell 10.

As such, the battery management system 70 of the battery module 1 according to the first embodiment of the present disclosure is provided with a circuit switching unit 74 to selectively connect the voltage measuring unit 72 to a particular member among several members.

Therefore, in this embodiment, the temperature and voltage of all the battery cells 10 provided in this battery module 1 may be measured by using a smaller number of voltage measuring units 72 than the number of voltage measuring member pairs 30, 40 or the number of temperature measuring member pairs 30, 50, so that the battery module 1 according to this embodiment may be configured more compactly and simply.

As described above, the battery module 1 according to the first embodiment of the present disclosure may utilize the voltage measuring member 30, thereby configuring a thermocouple with a simpler and more compact structure, which may be used to accurately measure temperature.

Additionally, the battery module 1 according to the first embodiment of the present disclosure may measure the voltage and temperature of all the battery cells 10 with a smaller number of voltage measuring units 72 by using the circuit switching unit 74, so that the components for measuring the temperature may be configured more simply and compactly.

This may increase the degree of design freedom and space utilization of the battery module 1.

Furthermore, in the battery module 1 according to the first embodiment of the present disclosure, the processor 76 considers information about the temperature of the reference temperature member 60 in the process of calculating the temperature of the battery cell 10, so that the temperature of the battery cell 10 may be calculated more accurately.

Meanwhile, although not shown in FIGS. 1 to 3, the battery module according to the first embodiment of the present disclosure may further include a housing for accommodating the above-described components or providing a base on which the above-described components may be installed. To this end, the housing may be made of metal or plastic having a predetermined rigidity, but is not limited thereto.

Hereinafter, a battery module according to the second embodiment of the present disclosure will be described with different drawings.

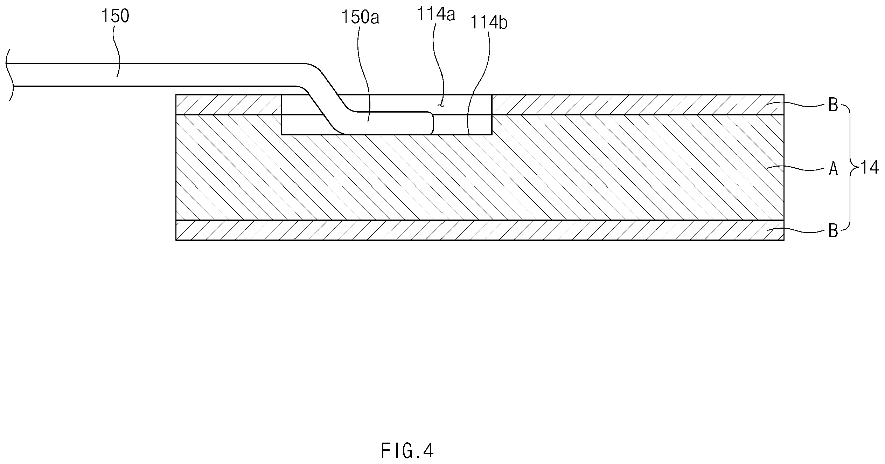

FIG. 4 is a cross-sectional view showing a state in which a temperature measuring member is coupled to a first electrode lead of a battery module according to the second embodiment of the present disclosure. At this time, each component of the battery module according to the second embodiment of the present disclosure is schematically shown in FIG. 4, and the size of the component, the thickness of the line, and the like may be somewhat exaggerated for convenience of understanding. And, the same reference numerals as in the drawings shown above refer to the same members performing the same function.

FIG. 4 discloses a first electrode lead 14 and a temperature measuring member 150 of a battery module according to the second embodiment of the present disclosure. In this embodiment, a predetermined groove 114a may be formed in the first electrode lead 14. And, the metal body A of the first electrode lead 14 may be exposed to the outside through the bottom surface 114b of the groove 114a.

In this embodiment, one side 150a of the temperature measuring member 150 may be coupled to the groove 114a of the first electrode lead 14. At this time, one side 150a may be configured to contact the bottom surface 114b of the groove 114a.

Through this, the temperature measuring member 150 and the metal body A may be electrically connected. Meanwhile, in order for one side 150a of the temperature measuring member 150 to be stably coupled to the metal body A, the one side 150a may be welded to the bottom surface 114b of the groove 114a.

The battery module according to embodiments of the present disclosure may be used as a configuration of a battery pack. The battery pack may be defined as an assembly in which at least one battery module is packaged. Such a battery pack may be installed in various facilities or locations to provide electric energy. As an example, the battery pack may be installed in a vehicle body of an electric vehicle to provide energy for driving a motor, but is not limited thereto.

The present disclosure has been hereinabove described with regard to a limited number of embodiments and drawings, but the present disclosure is not limited thereto and may be embodied in different forms by those having ordinary skill in the technical field pertaining to the present disclosure within the technical aspect of the present disclosure and the scope of the appended claims and their equivalents.

### [List of Reference Numerals]

1: Battery module
10: Battery cell
20: Connector
30: First voltage measuring member
40: Second voltage measuring member
50 150: Temperature measuring member
60: Reference temperature member
62: Temperature sensor
70: Battery management system

## Claims

1. A battery module comprising:
a battery cell comprising a cell body and a first electrode lead and a second electrode lead provided on one side and the other side of the cell body, respectively;
a first voltage measuring member and a second voltage measuring member electrically connected to the first electrode lead and the second electrode lead, respectively; and
a temperature measuring member coupled to the first electrode lead to form a thermocouple with the first voltage measuring member.

2. The battery module according to claim 1, further comprising:
a battery management system for controlling an operation of the battery cell,
wherein the battery management system comprises:
a voltage measuring unit that measures a voltage between the first voltage measuring member and the temperature measuring member or a voltage between the first voltage measuring member and the second voltage measuring member.

3. The battery module according to claim 2,
wherein the battery management system further comprises:
a processor unit that calculates a temperature of the battery cell based on a voltage difference between the first voltage measuring member and the temperature measuring member.

4. The battery module according to claim 2, further comprising:
a reference temperature member that exchanges heat with a portion of the first voltage measuring member and a portion of the temperature measuring member.

5. The battery module according to claim 4,
wherein the reference temperature member exchanges heat so that a portion of the first voltage measuring member and a portion of the temperature measuring member have the same temperature.

6. The battery module according to claim 4, further comprising:
a temperature sensor for measuring a temperature of the reference temperature member.

7. The battery module according to claim 6,
wherein the battery management system further comprises:
a processor unit that calculates a temperature of the battery cell based on a voltage between the first voltage measuring member and the temperature measuring member and a temperature of the reference temperature member.

8. The battery module according to claim 2,
wherein the battery management system further comprises:
a circuit switching unit capable of controlling electrical connections between the first voltage measuring member, the second voltage measuring member and the temperature measuring member, and the voltage measuring unit.

9. The battery module according to claim 1,
wherein the first electrode lead comprises a metal layer and a coating layer covering an outer surface of the metal layer, and a groove or hole where the metal layer is exposed to the outside is formed,
wherein one side of the temperature measuring member is in contact with an inner wall of the groove or hole of the first electrode lead.

10. The battery module according to claim 9,
wherein the one side of the temperature measuring member has a ring shape capable of being caught in the groove or hole.

11. The battery module according to claim 9,
wherein the one side of the temperature measuring member is coupled to an inner wall of the groove or hole.

12. The battery module according to claim 11,
wherein the one side of the temperature measuring member is welded to a bottom surface of the groove.

13. The battery module according to claim 1,
wherein the first voltage measuring member is made of copper having a purity of 99.5% or more, and
the temperature measuring member is made of constantan.

14. The battery module according to claim 1,
wherein the battery cell is provided in plurality, and
the first voltage measuring member, the second voltage measuring member, and the temperature measuring member are provided in plurality corresponding to the number of battery cells.

15. A battery pack comprising:
a battery module; and
a packaging that accommodates the battery module,
wherein the battery module comprises:
a battery cell comprising a cell body and a first electrode lead and a second electrode lead provided on one side and the other side of the cell body, respectively;
a first voltage measuring member and a second voltage measuring member electrically connected to the first electrode lead and the second electrode lead, respectively; and
a temperature measuring member coupled to the first electrode lead to form a thermocouple with the first voltage measuring member.
